(19) Europäisches Patentamt

European Patent Office

Office européen des brevets

(11) **EP 2 660 960 B1**

(12) **FASCICULE DE BREVET EUROPEEN**

(45) Date de publication et mention de la délivrance du brevet:
**29.04.2015 Bulletin 2015/18**

(51) Int Cl.:
**H02M 1/32** *(2007.01)*   **G01R 31/42** *(2006.01)*

(21) Numéro de dépôt: **13162058.5**

(22) Date de dépôt: **03.04.2013**

(54) **Procédé et système de détection d'un défaut sur le bus continu d'alimentation d'un convertisseur de puissance**

Verfahren und System zur Erkennung eines Fehlers auf der fortlaufenden Stromverteilungsschiene eines Leistungswandlers

Method and system for detecting a defect on the DC power supply bus of a power converter

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.05.2012 FR 1254072**

(43) Date de publication de la demande:
**06.11.2013 Bulletin 2013/45**

(73) Titulaire: **Schneider Toshiba Inverter Europe SAS 27120 Pacy sur Eure (FR)**

(72) Inventeurs:
• **Lechat, David**
  **27120 Pacy sur Eure (FR)**
• **Allaert, Yves-Laurent**
  **27200 VERNON (FR)**

(74) Mandataire: **Bié, Nicolas et al**
  **Schneider Electric Industries SAS**
  **Service Propriété Industrielle**
  **35 rue Joseph Monier - CS 30323**
  **92506 Rueil-Malmaison Cedex (FR)**

(56) Documents cités:
DE-A1- 10 244 765     DE-A1-102010 030 079
US-A1- 2004 095 784

**EP 2 660 960 B1**

**Description**

**Domaine technique de l'invention**

La présente invention se rapporte à un procédé de détection d'un défaut sur le bus continu d'alimentation d'un convertisseur de puissance.

L'invention se rapporte également à un système de détection apte à mettre en oeuvre ledit procédé.

**Etat de la technique**

De manière connue, un convertisseur de puissance comporte un bus continu d'alimentation sur lequel est appliquée une tension continue. Le bus continu d'alimentation comporte deux lignes d'alimentation. En amont du bus continu d'alimentation, le convertisseur de puissance comporte un module redresseur destiné à redresser la tension alternative fournie par un réseau de distribution électrique et à la convertir en une tension continue appliquée sur le bus. Un tel convertisseur de puissance comporte également un condensateur de bus connecté aux deux lignes d'alimentation du bus et destiné à maintenir la tension du bus à une valeur constante. Par ailleurs, un convertisseur de puissance peut comporter une inductance de filtrage connectée sur l'une, l'autre ou les deux lignes d'alimentation du bus continu d'alimentation, ainsi qu'un circuit de précharge, doté d'un relais de précharge, et employé au démarrage du variateur de vitesse.

En raison de la présence des différents composants, le bus continu d'alimentation est susceptible de présenter certains défauts de fonctionnement. Ces défauts sont par exemple :

- une usure avancée du condensateur de bus,

- un court-circuit entre les spires de l'inductance connectée sur le bus continu d'alimentation,

- une surcharge en tension du bus continu d'alimentation,

- une ouverture intempestive du relais de précharge ou sa non-fermeture.

Le document DE 10244765 montre un procédé de detection d'une usure avancée du condensateur de bus, le procédé comportant la détermination de l'ondulation de la tension du bus.

Les convertisseurs de puissance actuels ne sont pas protégés contre ces défauts et ne comportent aucun moyen simple pour les détecter.

Le but de l'invention est de proposer un procédé et un système de détection d'un défaut sur le bus continu d'alimentation d'un convertisseur de puissance. Pour la détection des défauts, le système de détection ne nécessite aucun capteur supplémentaire.

**Exposé de l'invention**

Ce but est atteint par un procédé de détection d'un défaut sur le bus continu d'alimentation d'un convertisseur de puissance connecté à un réseau de distribution électrique, ledit convertisseur de puissance comportant un module redresseur connecté au réseau de distribution électrique et destiné à convertir une tension fournie par le réseau de distribution électrique en une tension appliquée sur le bus continu d'alimentation, un condensateur de bus, une inductance et un circuit de précharge connectés au bus continu d'alimentation, ledit procédé comportant des étapes de :

- détermination d'une valeur moyenne de la tension du bus continu d'alimentation,
- détermination de l'ondulation de la tension du bus continu d'alimentation,
- surveillance de la variation de ladite valeur moyenne par rapport à ladite ondulation,
- détermination d'un défaut sur le bus continu d'alimentation en fonction de la vitesse de ladite variation, ledit défaut consistant en une anomalie sur l'inductance du bus continu d'alimentation, une surcharge en puissance du convertisseur de puissance, ou une usure avancée du condensateur de bus.

Selon une particularité, l'étape de surveillance consiste en une surveillance d'un ratio entre l'ondulation de la tension du bus continu d'alimentation et la valeur moyenne de la tension du bus continu d'alimentation.

Selon une autre particularité, l'étape de surveillance du ratio consiste à comparer ladite vitesse de variation par rapport à une première vitesse et à une deuxième vitesse.

Si la vitesse de variation du ratio est supérieure à la première vitesse, l'étape de détermination consiste à déterminer si la valeur moyenne de la tension du bus continu d'alimentation a varié. Si la valeur moyenne de la tension du bus continu d'alimentation a varié, le défaut consiste en une anomalie sur un relais de précharge du circuit de précharge. Si la valeur moyenne de la tension du bus continu d'alimentation n'a pas varié, le défaut consiste en une anomalie sur l'inductance.

En revanche, si la vitesse de variation du ratio est comprise entre la deuxième vitesse et la première vitesse, l'étape de détermination consiste à déterminer si la puissance fournie par le convertisseur de puissance a augmenté. Si la puissance fournie par le convertisseur de puissance a augmenté, le défaut consiste en une surcharge en puissance du convertisseur de tension. Si la puissance fournie par le convertisseur de puissance n'a pas augmenté, l'étape de détermination comporte une étape de comparaison entre une valeur fonction du ratio et une valeur limite. Selon le résultat de la comparaison effectuée, le défaut consiste en une usure avancée du condensateur de bus ou une variation de la fréquence du réseau de distribution électrique.

Selon l'invention, l'ondulation est préférentiellement mesurée sur le premier harmonique de la tension du bus continu d'alimentation et entre deux valeurs extrêmes successives.

L'invention concerne également un système de détection d'un défaut sur le bus continu d'alimentation d'un convertisseur de puissance connecté à un réseau de distribution électrique, ledit convertisseur de puissance comportant un module redresseur connecté au réseau de distribution électrique et destiné à convertir une tension fournie par le réseau de distribution électrique en une tension appliquée sur le bus continu d'alimentation, un condensateur de bus, une inductance et un circuit de précharge connectés au bus continu d'alimentation, ledit système comportant :

- des premiers moyens de détermination d'une valeur moyenne de la tension du bus continu d'alimentation,
- des deuxièmes moyens de détermination de l'ondulation de la tension du bus continu d'alimentation,
- des moyens de surveillance de la variation de ladite valeur moyenne par rapport à ladite ondulation,
- des troisièmes moyens de détermination d'un défaut sur le bus continu d'alimentation en fonction de la vitesse de ladite variation, ledit défaut consistant en une anomalie sur l'inductance du bus continu d'alimentation, une surcharge en puissance du convertisseur de puissance, ou une usure avancée du condensateur de bus.

Selon une particularité, le système comporte des quatrièmes moyens de détermination d'un ratio entre l'ondulation de la tension du bus continu d'alimentation et la valeur moyenne de la tension du bus continu d'alimentation.

Selon une autre particularité, les moyens de surveillance sont agencés pour comparer une vitesse de variation du ratio par rapport à une première vitesse et à une deuxième vitesse.

Si la vitesse de variation du ratio est supérieure à la première vitesse, les troisièmes moyens de détermination sont agencés pour surveiller la variation de la valeur moyenne de la tension du bus continu d'alimentation. Si la valeur moyenne de la tension du bus continu d'alimentation a varié, le défaut consiste en une anomalie sur un relais de précharge du circuit de précharge. Si la valeur moyenne de la tension du bus continu d'alimentation n'a pas varié, le défaut consiste en une anomalie sur l'inductance.

Si la vitesse de variation du ratio est comprise entre la deuxième vitesse et la première vitesse, les troisièmes moyens de détermination sont agencés pour surveiller la variation de la puissance fournie par le convertisseur de puissance. Si la puissance fournie par le convertisseur de puissance a augmenté, le défaut consiste en une surcharge en puissance du convertisseur de tension. Si la puissance fournie par le convertisseur de puissance n'a pas augmenté, les troisièmes moyens de détermination sont agencés pour mettre en oeuvre une comparaison entre une valeur fonction du ratio et une valeur limite. Selon le résultat de la comparaison effectuée, le défaut consiste en une usure avancée du condensateur de bus ou une variation de la fréquence du réseau de distribution électrique.

Selon l'invention, le système comporte des moyens de mesure ou d'estimation de la température interne du condensateur de bus.

**Brève description des figures**

D'autres caractéristiques et avantages vont apparaître dans la description détaillée qui suit faite en regard des dessins annexés dans lesquels :

- la figure 1 représente un convertisseur de puissance incluant le système de détection de l'invention,

- la figure 2 représente l'algorithme mis en oeuvre dans le procédé de détection de l'invention.

**Description détaillée d'au moins un mode de réalisation**

L'invention concerne un procédé de détection d'un défaut sur le bus continu d'alimentation d'un convertisseur de puissance. Ce procédé de détection est mis en oeuvre dans un système de détection S qui est inclus dans le convertisseur de puissance ou connecté à celui-ci.

L'invention s'applique à un convertisseur de puissance qui comporte :

- un module redresseur REC connecté à réseau RD de distribution électrique et destiné à convertir la tension alternative fournie par le réseau RD en une tension Vbus continue.

- un bus continu d'alimentation comportant deux lignes d'alimentation, une première ligne d'alimentation 10 à potentiel électrique positif et une deuxième ligne d'alimentation 11 à potentiel électrique négatif. En sortie du module redresseur REC, la tension Vbus est appliquée sur le bus continu d'alimentation.

- un condensateur de bus Cbus connecté à la première ligne d'alimentation 10 et à la deuxième ligne d'alimentation 11 du bus et destiné à maintenir la tension Vbus du bus continu d'alimentation à une valeur constante. Bien entendu, par condensateur de bus Cbus, on entend également un banc comportant plusieurs condensateurs connectés entre eux.

- au moins une inductance L1 de filtrage connectée en série sur la première ligne d'alimentation 10 et/ou sur la deuxième ligne d'alimentation 11, en amont du condensateur de bus Cbus.

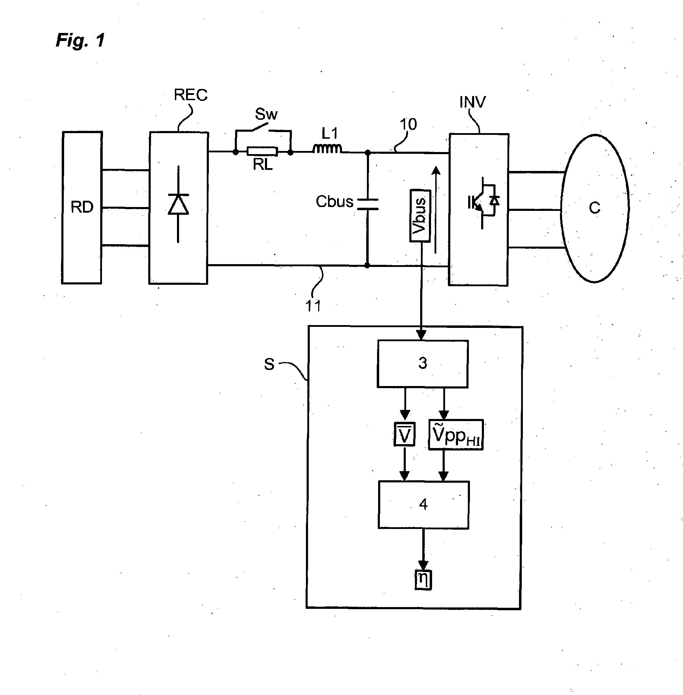

- un circuit de précharge connecté en série sur la première ligne d'alimentation 10 (comme sur la figure 1) ou la deuxième ligne d'alimentation 11 du bus ou en série avec le condensateur de bus Cbus. Habituellement, ce circuit de précharge comporte une résistance de limitation RL, en parallèle de laquelle est monté un relais de précharge Sw. Cette résistance de limitation RL est active au démarrage pendant la phase de charge du bus continu d'alimentation. Elle permet de limiter le courant d'entrée à travers le module redresseur REC. Une fois le condensateur de bus Cbus chargé, la résistance de limitation RL est court-circuitée par fermeture du relais Sw monté en parallèle.

Par ailleurs, l'invention peut également s'appliquer à un convertisseur de puissance qui comporte un module onduleur INV connecté en aval du bus continu d'alimentation et employé pour convertir la tension Vbus continue appliquée sur le bus en une tension variable à destination d'une charge électrique C.

Le procédé de l'invention permet de détecter un défaut se produisant sur le bus continu d'alimentation du convertisseur de puissance. Ce procédé est mis en oeuvre dans le système de détection S en s'appuyant uniquement sur la mesure de la tension Vbus du bus continu d'alimentation.

La tension Vbus du bus continu d'alimentation se décompose en une valeur moyenne ($\overline{V}$) et une ondulation ($\tilde{V}$) autour de sa valeur moyenne.

La tension Vbus s'exprime ainsi de la manière suivante :

$$V_{bus} = \overline{V} + \tilde{V}$$

Une fois la conduction continue atteinte, si on ne considère que le premier harmonique, la tension Vbus du bus continu d'alimentation est :

$$V_{bus} = \overline{V} + \tilde{V}_{H1} * \cos(6\dot{\omega}_R t)$$

La valeur moyenne $\overline{V}$ de la tension Vbus du bus continu d'alimentation vaut : $\overline{V} = \dfrac{3}{\pi} V_{main} \sqrt{2}\sqrt{3}$ avec $V_{main}$ la tension réseau simple.

Le premier harmonique de l'ondulation de tension du bus est :

$$\tilde{V}_{H1} = V_{main} \sqrt{2}\sqrt{3} \frac{6}{35\pi} \frac{1}{\sqrt{\left(1 - \left(\dfrac{6f_R}{f_0}\right)^2\right)^2}}$$

Avec:

$f_R$ la fréquence du réseau,
$f_0$ la fréquence de coupure du filtre LC.

Selon l'invention, il s'agit d'observer la variation de la valeur moyenne V de la tension Vbus du bus continu d'alimentation par rapport à l'ondulation V de la tension Vbus du bus continu d'alimentation lorsque la puissance délivrée par le convertisseur de puissance est suffisante pour permettre une conduction continue du bus d'alimentation. La mesure de l'ondulation est réalisée sur le premier harmonique et entre deux valeurs extrêmes successives ($\tilde{V}pp_{H1}$ = ondulation pic de tension à pic de tension). Cette surveillance est ainsi réalisée à partir d'un ratio $\eta$ entre l'ondulation $\tilde{V}pp_{H1}$ de la tension Vbus du bus continu d'alimentation et la valeur moyenne V de la tension Vbus du bus continu d'alimentation.

Le ratio s'exprime ainsi de la manière suivante :

$$\eta = \frac{\tilde{V}pp_{H1}}{\overline{V}}$$

Dans laquelle :

$$\tilde{V}pp_{H1} = \frac{4\overline{V}}{35} \frac{1}{\sqrt{\left(1 - \left(\frac{6f_R}{f_0}\right)^2\right)^2}}$$

Comme généralement $\frac{6f_R}{f_0} \gg 1$, il est alors possible de faire l'approximation suivante :

$$\sqrt{\left(1 - \left(\frac{6f_R}{f_0}\right)^2\right)^2} = \left(\frac{6f_R}{f_0}\right)^2$$

Soit :

$$\tilde{V}pp_{H1} = \frac{4\overline{V}}{35} \frac{1}{\left(\frac{6f_R}{f_0}\right)^2} = \frac{4\overline{V}}{35} \left(\frac{f_0}{6f_R}\right)^2 = \frac{\overline{V}}{35(6\pi f_R)^2 LC}$$

A partir de l'approximation précédente, le ratio $\eta$ entre l'ondulation de la tension du bus et la valeur moyenne de la tension du bus s'écrit :

$$\frac{\tilde{V}pp_{H1}}{\overline{V}} = \frac{1}{35(6\pi f_R)^2 LC}$$

Le ratio $\eta$ peut se réécrire sous la forme suivante :

$$\frac{\tilde{V}pp_{H1}}{\overline{V}} = k\left(\frac{f_0}{f_R}\right)^2 = \eta$$

A des intervalles de temps déterminés ou aléatoires, le système de détection récupère donc la mesure de la tension Vbus du bus continu d'alimentation et met en oeuvre des moyens de détermination 3 de la valeur moyenne ($\overline{V}$) de la tension Vbus du bus continu d'alimentation et de l'ondulation ($\tilde{V}pp_{H1}$) de la tension Vbus du bus continu d'alimentation. Puis, le système de détection met en oeuvre des moyens de détermination 4 du ratio $\eta$ à partir de cette valeur moyenne ($\overline{V}$) de la tension Vbus du bus continu d'alimentation et de l'ondulation ($\tilde{V}pp_{H1}$) correspondante de la tension Vbus du bus continu d'alimentation.

Ensuite, le système de détection S de l'invention met en oeuvre un algorithme de surveillance du ratio $\eta$ lui permettant de détecter un défaut éventuel sur le bus continu d'alimentation.

Dans cet algorithme, le système de détection tient compte de l'augmentation rapide ou lente du ratio $\eta$. L'augmentation rapide ou lente du ratio $\eta$ pourra être réalisée par comparaison de la vitesse $v_\eta$ de variation du ratio par rapport à une première vitesse $v_1$ (correspondant à une variation d'au moins de 10% en moins d'une seconde) et à une deuxième vitesse $v_2$ (correspondant à une variation de 25% sur plusieurs années), inférieure à la première vitesse $v_1$. Si la vitesse $v_\eta$ d'augmentation du ratio est supérieure à la première vitesse $v_1$, l'augmentation sera considérée comme rapide et si la vitesse $v_\eta$ d'augmentation du ratio est comprise entre la deuxième vitesse $v_2$ et la première vitesse $v_1$, l'augmentation sera considérée comme lente.

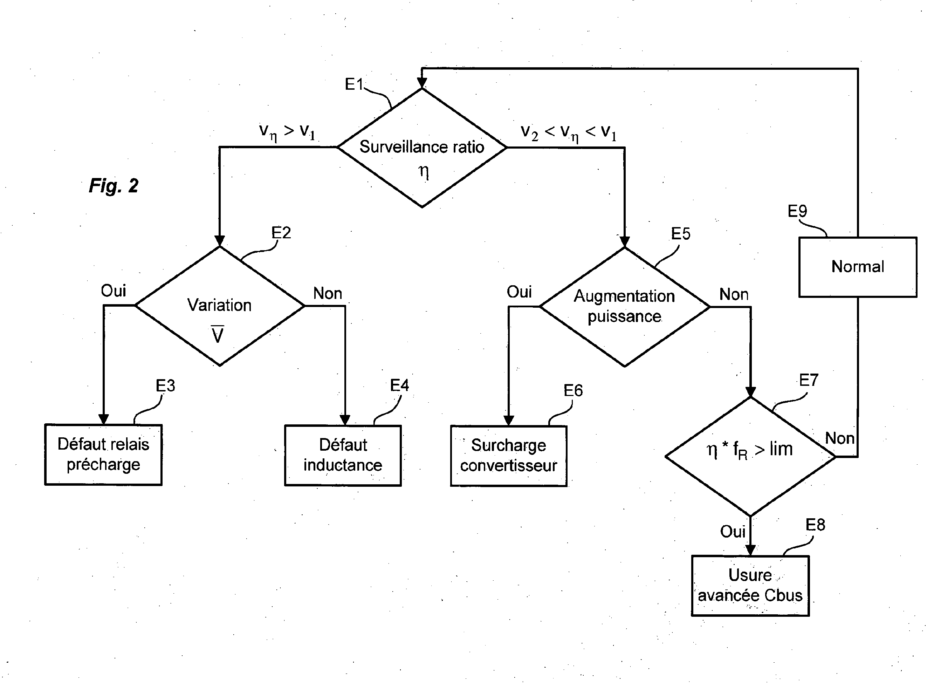

L'algorithme de détection est schématisé sur la figure 2.

Dans une étape E1, le système de détection S surveille le ratio $\eta$. Si un modèle thermique du condensateur de bus Cbus est disponible, le système de détection S peut ramener le ratio $\eta$ à une température de référence afin d'améliorer la précision de mesure de $\eta$.

Une augmentation rapide du ratio $\eta$ lors du fonctionnement du convertisseur de puissance peut avoir deux causes :

- ouverture du relais de précharge Sw si le convertisseur comporte un tel relais,

- court-circuit entre plusieurs spires de l'inductance L1 du bus continu d'alimentation.

Dans une étape E2, pour discriminer ces deux défauts, le système de détection S détermine alors si cette augmentation rapide est liée à une variation de la valeur moyenne V de la tension Vbus du bus continu d'alimentation.

Si une variation de la valeur moyenne $\overline{V}$ de la tension Vbus du bus continu d'alimentation accompagne l'augmentation rapide du ratio $\eta$, alors le défaut provient certainement de l'ouverture du relais de précharge Sw. Dans une étape E3, le système de détection S conclut donc à un défaut sur le relais de précharge Sw et le signale par exemple à l'opérateur.

En revanche, si l'augmentation rapide du ratio $\eta$ n'est pas liée à une variation de la valeur moyenne V de la tension Vbus du bus continu d'alimentation, alors cela signifie que le défaut provient certainement d'un court-circuit entre les spires de l'inductance L1. Dans une étape E4, le système de détection S conclut donc à un défaut sur l'inductance L1 de filtrage du bus continu d'alimentation et le signale par exemple à l'opérateur.

La détection de ces deux défauts est valable, quelle que soit la position du circuit de précharge, c'est-à-dire en série sur une ligne d'alimentation 10, 11 du bus continu d'alimentation (comme sur la figure 1) ou en série avec le condensateur de bus Cbus. Dans ce deuxième cas, pour pouvoir déterminer la nature du défaut, la mesure de la tension Vbus du bus continu d'alimentation ne doit cependant pas inclure la tension aux bornes du circuit de précharge.

En référence à la figure 2, une augmentation lente du ratio $\eta$ lors du fonctionnement normal du convertisseur de puissance peut avoir trois causes distinctes :

- surcharge en tension du convertisseur de puissance,

- usure avancée du condensateur de bus,

- variation de la fréquence du réseau de distribution électrique.

En cas d'augmentation lente du ratio $\eta$, le système de détection S vérifie, dans une étape E5, le niveau de la puissance Pf fournie par le convertisseur de puissance. Si la puissance Pf fournie par le convertisseur de puissance a augmenté, alors le défaut provient certainement d'une surcharge en puissance du convertisseur de puissance. Dans une étape E6, le système de détection S conclut donc à un défaut lié à une surcharge en puissance du convertisseur de puissance et le signale par exemple à l'opérateur.

En revanche, si la puissance Pf fournie par le convertisseur de puissance n'a pas augmenté, alors le système de détection S détermine si le défaut est lié à une usure avancée du condensateur de bus Cbus. Pour cela, dans une étape E7, le système de détection S effectue une comparaison par rapport à une valeur limite (lim), cette valeur limite étant déterminée à partir d'une valeur de référence $\eta_0$ du ratio. Cette valeur de référence $\eta_0$ est par exemple déterminée à la première mise sous tension du convertisseur et mémorisée par le système de détection S. Deux solutions sont alors envisageables :

- si la fréquence du réseau $f_R$ est mesurée, alors le système de détection S multiplie le ratio $\eta$ par la fréquence $f_R$ du réseau RD et compare le résultat au produit de la valeur de référence $\eta_0$ du ratio avec la fréquence $f_R$ du réseau. Le condensateur de bus Cbus sera en fin de vie lorsque la valeur du produit $\eta * f_R$ sera supérieure de 25% à $\eta_0 * f_R$.

- Si la fréquence $f_R$ du réseau n'est pas mesurée, alors le système de détection compare le ratio $\eta$ à l'expression

$$\eta_0 \left( \frac{1 + \text{tol}}{1 - \text{tol}} \right)^2$$ avec "tol" la tolérance sur la valeur de la fréquence réseau. Le condensateur de bus sera en fin

de vie lorsque : $\eta \geq \eta_0 \left( \frac{1 + \text{tol}}{1 - \text{tol}} \right)^2$ .

A l'étape E7 de la figure 2, la comparaison est effectuée en considérant la mesure de la fréquence $f_R$ du réseau disponible.

Si la fréquence du réseau de distribution électrique est mesurée, la surveillance du produit $\eta * f_R$ revient directement à surveiller l'inverse de la valeur de la capacité du condensateur de bus. Ainsi, si le système de détection dispose d'un modèle thermique du condensateur de bus employant des moyens de mesure ou d'estimation de la température interne du condensateur de bus, il lui est possible d'évaluer plus précisément la durée de vie restante du condensateur de bus.

Lors de la comparaison effectuée à l'étape E7, si le système de détection S conclut que le ratio $\eta$ ou le produit du ratio $\eta$ avec la fréquence $f_R$ du réseau est supérieur à la valeur limite (lim), alors le système de détection S conclut, à l'étape E8, à l'usure avancée du condensateur de bus Cbus et le signale par exemple à l'opérateur.

En revanche, à l'étape E7, si le système de détection S conclut que le ratio $\eta$ ou le produit du ratio $\eta$ avec la fréquence $f_R$ du réseau n'est pas supérieur à la valeur limite (lim), alors le système de détection S conclut, à l'étape E9, en l'absence de défaut dans le convertisseur de puissance. L'augmentation lente du ratio $\eta$ n'était alors due qu'à une variation de la fréquence $f_R$ du réseau de distribution électrique. Le système de détection peut alors reprendre la surveillance du ratio à l'étape E1.

## Revendications

1. Procédé de détection d'un défaut sur le bus continu d'alimentation d'un convertisseur de puissance connecté à un réseau (RD) de distribution électrique, ledit convertisseur de puissance comportant un module redresseur (REC) connecté au réseau (RD) de distribution électrique et destiné à convertir une tension fournie par le réseau (RD) de distribution électrique en une tension (Vbus) appliquée sur le bus continu d'alimentation, un condensateur de bus (Cbus), une inductance (L1) et un circuit de précharge connectés au bus continu d'alimentation, ledit procédé comportant des étapes de :

   - détermination d'une valeur moyenne ($\overline{V}$) de la tension (Vbus) du bus continu d'alimentation,
   - détermination de l'ondulation ($\tilde{V}pp_{H1}$) de la tension (Vbus) du bus continu d'alimentation,
   - surveillance de la variation de ladite valeur moyenne ($\overline{V}$) par rapport à ladite ondulation ($\tilde{V}pp_{H1}$),
   - détermination d'un défaut sur le bus continu d'alimentation en fonction de la vitesse de ladite variation, ledit défaut consistant en une anomalie sur l'inductance (L1) du bus continu d'alimentation, une surcharge en puissance du convertisseur de puissance, ou une usure avancée du condensateur de bus (Cbus).

2. Procédé selon la revendication 1, **caractérisé en ce que** l'étape (E1) de surveillance consiste en une surveillance d'un ratio ($\eta$) entre l'ondulation ($\tilde{V}pp_{H1}$) de la tension (Vbus) du bus continu d'alimentation et la valeur moyenne ($\overline{V}$) de la tension (Vbus) du bus continu d'alimentation.

3. Procédé selon la revendication 2, **caractérisé en ce que** l'étape (E1) de surveillance du ratio ($\eta$) consiste à comparer ladite vitesse ($v_\eta$) de variation par rapport à une première vitesse ($v_1$) et à une deuxième vitesse ($v_2$).

4. Procédé selon la revendication 3, **caractérisé en ce que**, si la vitesse ($v_\eta$) de variation du ratio est supérieure à la première vitesse ($v_1$), l'étape de détermination consiste à déterminer si la valeur moyenne (V) de la tension (Vbus) du bus continu d'alimentation a varié.

5. Procédé selon la revendication 4, **caractérisé en ce que**, si la valeur moyenne ($\overline{V}$) de la tension (Vbus) du bus continu d'alimentation a varié, le défaut consiste en une anomalie sur un relais de précharge (Sw) du circuit de précharge et **en ce que**, si la valeur moyenne ($\overline{V}$) de la tension (Vbus) du bus continu d'alimentation n'a pas varié, le défaut consiste en une anomalie sur l'inductance (L1).

6. Procédé selon la revendication 3, **caractérisé en ce que**, si la vitesse ($v_\eta$) de variation du ratio est comprise entre la deuxième vitesse ($v_2$) et la première vitesse ($v_1$), l'étape de détermination consiste à déterminer si la puissance (Pf) fournie par le convertisseur de puissance a augmenté.

7. Procédé selon la revendication 6, **caractérisé en ce que**, si la puissance (Pf) fournie par le convertisseur de puissance a augmenté, le défaut consiste en une surcharge en puissance du convertisseur de tension et **en ce que**, si la puissance fournie par le convertisseur de puissance n'a pas augmenté, l'étape de détermination comporte une étape de comparaison entre une valeur fonction du ratio ($\eta$) et une valeur limite (lim).

8. Procédé selon la revendication 7, **caractérisé en ce que** selon le résultat de la comparaison effectuée, le défaut consiste en une usure avancée du condensateur de bus (Cbus) ou une variation de la fréquence ($f_R$) du réseau (RD) de distribution électrique.

9. Procédé selon l'une des revendications 1 à 8, **caractérisé en ce que** l'ondulation est mesurée sur le premier harmonique de la tension du bus continu d'alimentation et entre deux valeurs extrêmes successives.

10. Système de détection d'un défaut sur le bus continu d'alimentation d'un convertisseur de puissance connecté à un réseau (RD) de distribution électrique, ledit convertisseur de puissance comportant un module redresseur (REC) connecté au réseau (RD) de distribution électrique et destiné à convertir une tension fournie par le réseau (RD) de distribution électrique en une tension (Vbus) appliquée sur le bus continu d'alimentation, un condensateur de bus (Cbus), une inductance (L1) et un circuit de précharge connectés au bus continu d'alimentation, ledit système comportant :

- des premiers moyens de détermination d'une valeur moyenne ($\overline{V}$) de la tension (Vbus) du bus continu d'alimentation,
- des deuxièmes moyens de détermination de l'ondulation ($\tilde{V}pp_{H1}$) de la tension (Vbus) du bus continu d'alimentation,
- des moyens de surveillance de la variation de ladite valeur moyenne ($\overline{V}$) par rapport à ladite ondulation ($\tilde{V}pp_{H1}$),
- des troisièmes moyens de détermination d'un défaut sur le bus continu d'alimentation en fonction de la vitesse de ladite variation, ledit défaut consistant en une anomalie sur l'inductance (L1) du bus continu d'alimentation, une surcharge en puissance du convertisseur de puissance, ou une usure avancée du condensateur de bus (Cbus).

11. Système selon la revendication 10, **caractérisé en ce qu'**il comporte des quatrièmes moyens de détermination d'un ratio ($\eta$) entre l'ondulation ($\tilde{V}pp_{H1}$) de la tension (Vbus) du bus continu d'alimentation et la valeur moyenne ($\overline{V}$) de la tension (Vbus) du bus continu d'alimentation.

12. Système selon la revendication 11, caractérisé en ce les moyens de surveillance sont agencés pour comparer une vitesse ($v_\eta$) de variation du ratio par rapport à une première vitesse ($v_1$) et à une deuxième vitesse ($v_2$).

13. Système selon la revendication 12, **caractérisé en ce que**, si la vitesse ($v_\eta$) de variation du ratio est supérieure à la première vitesse ($v_1$), les troisièmes moyens de détermination sont agencés pour surveiller la variation de la valeur moyenne ($\overline{V}$) de la tension (Vbus) du bus continu d'alimentation.

14. Système selon la revendication 13, **caractérisé en ce que**, si la valeur moyenne ($\overline{V}$) de la tension (Vbus) du bus continu d'alimentation a varié, le défaut consiste en une anomalie sur un relais de précharge (Sw) du circuit de précharge et **en ce que**, si la valeur moyenne ($\overline{V}$) de la tension (Vbus) du bus continu d'alimentation n'a pas varié, le défaut consiste en une anomalie sur l'inductance (L1).

**15.** Système selon la revendication 12, **caractérisé en ce que**, si la vitesse ($v_\eta$) de variation du ratio est comprise entre la deuxième vitesse ($v_2$) et la première vitesse ($v_1$), les troisièmes moyens de détermination sont agencés pour surveiller la variation de la puissance (Pf) fournie par le convertisseur de puissance.

**16.** Système selon la revendication 15, **caractérisé en ce que**, si la puissance (Pf) fournie par le convertisseur de puissance a augmenté, le défaut consiste en une surcharge en puissance du convertisseur de tension et **en ce que**, si la puissance fournie par le convertisseur de puissance n'a pas augmenté, les troisièmes moyens de détermination sont agencés pour mettre en oeuvre une comparaison entre une valeur fonction du ratio ($\eta$) et une valeur limite (lim).

**17.** Système selon la revendication 16, **caractérisé en ce que**, selon le résultat de la comparaison effectuée, le défaut consiste en une usure avancée du condensateur de bus (Cbus) ou une variation de la fréquence ($f_R$) du réseau (RD) de distribution électrique.

**18.** Système selon l'une des revendications 10 à 17, **caractérisé en ce qu'il** comporte des moyens de mesure ou d'estimation de la température interne du condensateur de bus (Cbus).

**Patentansprüche**

**1.** Verfahren zur Erkennung eines Fehlers auf der durchgehenden Stromversetgungsschiene eines Leistungswandlers, der an ein Stromverteilungsnetz (RD) angeschlossen ist, wobei der Leistungswandler ein Gleichrichtermodul (REC), das an das Stromverteilungsnetz (RD) angeschlossen ist und dazu bestimmt ist, eine von dem Stromverteilungsnetz (RD) gelieferte Spannung in eine an die durchgehende Stromversetgungsschiene angelegte Spannung (Vbus) umzuwandeln, einen Buskondensator (Cbus), eine Induktivität (L1) und eine Vorladungsschaltung, die an die Stromversetgungsschiene angeschlossen sind, aufweist, wobei das Verfahren die folgenden Schritte aufweist:

- Bestimmung eines Mittelwertes ($\overline{V}$) der Spannung (Vbus) der durchgehenden Stromverteilungsschiene,
- Bestimmung der Welligkeit ($\tilde{V}pp_{H1}$) der Spannung (Vbus) der durchgehenden Stromverteilungsschiene,
- Überwachung der Änderung des Mittelwertes ($\overline{V}$) in Bezug auf die Welligkeit ($\tilde{V}pp_{H1}$),
- Bestimmung eines Fehlers auf der durchgehenden Stromversetgungsschiene in Abhängigkeit von der Geschwindigkeit dieser Änderung, wobei der Fehler in einer Anomalie an der Induktivität (L1) der durchgehenden Stromverteilungsschiene, einer Leistungsüberlastung des Leistungswandlers oder einem erhöhten Verschleiß des Buskondensators (Cbus) besteht.

**2.** Verfahren nach Anspruch 1, **dadurch gekennzeichnet, dass** der Schritt (E1) der Überwachung in einer Überwachung eines Verhältnisses ($\eta$) zwischen der Welligkeit ($\tilde{V}pp_{H1}$) der Spannung (Vbus) der durchgehenden Stromversetgungsschiene und dem Mittelwert ($\overline{V}$) der Spannung (Vbus) der durchgehenden Stromversetgungsschiene besteht.

**3.** Verfahren nach Anspruch 2, **dadurch gekennzeichnet, dass** der Schritt (E1) der Überwachung des Verhältnisses ($\eta$) darin besteht, die Geschwindigkeit ($v_\eta$) der Änderung in Bezug auf eine erste Geschwindigkeit ($v_1$) und auf eine zweite Geschwindigkeit ($v_2$) zu vergleichen.

**4.** Verfahren nach Anspruch 3, **dadurch gekennzeichnet, dass**, falls die Geschwindigkeit ($v_\eta$) der Änderung des Verhältnisses größer als die erste Geschwindigkeit ($v_1$) ist, der Schritt der Bestimmung darin besteht zu bestimmen, ob sich der Mittelwert ($\overline{V}$) der Spannung (Vbus) der durchgehenden Stromversetgungsschiene geändert hat.

**5.** Verfahren nach Anspruch 4, **dadurch gekennzeichnet, dass**, falls sich der Mittelwert ($\overline{V}$) der Spannung (Vbus) der durchgehenden Stromversetgungsschiene geändert hat, der Fehler in einer Anomalie an einem Vorladungsrelais (Sw) der Vorladungsschaltung besteht, und dadurch, dass, falls sich der Mittelwert ($\overline{V}$) der Spannung (Vbus) der durchgehenden Stromversetgungsschiene nicht geändert hat, der Fehler in einer Anomalie an der Induktivität (L1) besteht.

6. Verfahren nach Anspruch 3, **dadurch gekennzeichnet, dass**, falls die Geschwindigkeit ($v_\eta$) der Änderung des Verhältnisses zwischen der zweiten Geschwindigkeit ($v_2$) und der ersten Geschwindigkeit ($v_1$) liegt, der Schritt der Bestimmung darin besteht zu bestimmen, ob sich die von dem Leistungswandler gelieferte Leistung (Pf) erhöht hat.

7. Verfahren nach Anspruch 6, **dadurch gekennzeichnet, dass**, falls sich die von dem Leistungswandler gelieferte Leistung (Pf) erhöht hat, der Fehler in einer Leistungsüberlastung des Spannungswandlers besteht, und dadurch, dass, falls sich die von dem Leistungswandler gelieferte Leistung nicht erhöht hat, der Schritt der Bestimmung einen Schritt des Vergleichs zwischen einem von dem Verhältnis ($\eta$) abhängigen Wert und einem Grenzwert (lim) aufweist.

8. Verfahren nach Anspruch 7, **dadurch gekennzeichnet, dass** je nach dem Ergebnis des durchgeführten Vergleichs der Fehler in einem erhöhten Verschleiß des Buskondensators (Cbus) oder in einer Änderung der Frequenz ($f_R$) des Stromverteilungsnetzes (RD) besteht.

9. Verfahren nach einem der Ansprüche 1 bis 8, **dadurch gekennzeichnet, dass** die Welligkeit an der ersten Harmonischen der Spannung der durchgehenden Stromversetgungsschiene und zwischen zwei aufeinander folgenden Extremwerten gemessen wird.

10. System zur Erkennung eines Fehlers auf der durchgehenden Stromversetgungsschiene eines Leistungswandlers, der an ein Stromverteilungsnetz (RD) angeschlossen ist, wobei der Leistungswandler ein Gleichrichtermodul (REC), das an das Stromverteilungsnetz (RD) angeschlossen ist und dazu bestimmt ist, eine von dem Stromverteilungsnetz (RD) gelieferte Spannung in eine an die durchgehende Stromversetgungsschiene angelegte Spannung (Vbus) umzuwandeln, einen Buskondensator (Cbus), eine Induktivität (L1) und eine Vorladungsschaltung, die an die Stromversetgungsschiene angeschlossen sind, aufweist, wobei das System aufweist:

   - erste Mittel zur Bestimmung eines Mittelwertes ($\overline{V}$) der Spannung (Vbus) der durchgehenden Stromverteilungsschiene,
   - zweite Mittel zur Bestimmung der Welligkeit ($\tilde{V}pp_{H1}$) der Spannung (Vbus) der durchgehenden Stromverteilungsschiene,
   - Mittel zur Überwachung der Änderung des Mittelwertes ($\overline{V}$) in Bezug auf die Welligkeit ($\tilde{V}pp_{H1}$),
   - dritte Mittel zur Bestimmung eines Fehlers auf der durchgehenden Stromversetgungsschiene in Abhängigkeit von der Geschwindigkeit dieser Änderung, wobei der Fehler in einer Anomalie an der Induktivität (L1) der durchgehenden Stromverteilungsschiene, einer Leistungsüberlastung des Leistungswandlers oder einem erhöhten Verschleiß des Buskondensators (Cbus) besteht.

11. System nach Anspruch 10, **dadurch gekennzeichnet, dass** es vierte Mittel zur Bestimmung eines Verhältnisses ($\eta$) zwischen der Welligkeit ($\tilde{V}pp_{H1}$) der Spannung (Vbus) der durchgehenden Stromversetgungsschiene und dem Mittelwert ($\overline{V}$) der Spannung (Vbus) der durchgehenden Stromversetgungsschiene aufweist.

12. System nach Anspruch 11, **dadurch gekennzeichnet, dass** die Mittel zur Überwachung dafür ausgelegt sind, eine Geschwindigkeit ($v_\eta$) der Änderung des Verhältnisses in Bezug auf eine erste Geschwindigkeit ($v_1$) und auf eine zweite Geschwindigkeit ($v_2$) zu vergleichen.

13. System nach Anspruch 12, **dadurch gekennzeichnet, dass**, falls die Geschwindigkeit ($v_\eta$) der Änderung des Verhältnisses größer als die erste Geschwindigkeit ($v_1$) ist, die dritten Mittel zur Bestimmung dafür ausgelegt sind, die Änderung des Mittelwertes ($\overline{V}$) der Spannung (Vbus) der durchgehenden Stromversetgungsschiene zu überwachen.

14. System nach Anspruch 13, **dadurch gekennzeichnet, dass**, falls sich der Mittelwert ($\overline{V}$) der Spannung (Vbus) der durchgehenden Stromversetgungsschiene geändert hat, der Fehler in einer Anomalie an einem Vorladungsrelais (Sw) der Vorladungsschaltung besteht, und dadurch, dass, falls sich der Mittelwert ($\overline{V}$) der Spannung (Vbus) der durchgehenden Stromversetgungsschiene nicht geändert hat, der Fehler in einer Anomalie an der Induktivität (L1) besteht.

15. System nach Anspruch 12, **dadurch gekennzeichnet, dass**, falls die Geschwindigkeit ($v\eta$) der Änderung des Verhältnisses zwischen der zweiten Geschwindigkeit ($v_2$) und der ersten Geschwindigkeit ($v_1$) liegt, die dritten Mittel zur Bestimmung dafür ausgelegt sind, die Änderung der von dem Leistungswandler gelieferten Leistung (Pf) zu überwachen.

16. System nach Anspruch 15, **dadurch gekennzeichnet, dass**, falls sich die von dem Leistungswandler gelieferte Leistung (Pf) erhöht hat, der Fehler in einer Leistungsüberlastung des Spannungswandlers besteht, und dadurch, dass, falls sich die von dem Leistungswandler gelieferte Leistung nicht erhöht hat, die dritten Mittel zur Bestimmung dafür ausgelegt sind, einen Vergleich zwischen einem von dem Verhältnis ($\eta$) abhängigen Wert und einem Grenzwert (lim) durchzuführen.

17. System nach Anspruch 16, **dadurch gekennzeichnet, dass** je nach dem Ergebnis des durchgeführten Vergleichs der Fehler in einem erhöhten Verschleiß des Buskondensators (Cbus) oder in einer Änderung der Frequenz ($f_R$) des Stromverteilungsnetzes (RD) besteht.

18. System nach einem der Ansprüche 10 bis 17, **dadurch gekennzeichnet, dass** es Mittel zur Messung oder Schätzung der Innentemperatur des Buskondensators (Cbus) aufweist.

## Claims

1. Method for detecting a defect on the DC power supply bus of a power converter connected to an electrical distribution network (RD), the said power converter comprising a rectifier module (REC) connected to the electrical distribution network (RD) and intended to convert a voltage provided by the electrical distribution network (RD) into a voltage (Vbus) applied to the DC power supply bus, a bus capacitor (Cbus), an inductor (L1) and a precharge circuit connected to the DC power supply bus, the said method comprising steps of:

   - determination of a mean value ($\overline{V}$) of the voltage (Vbus) of the DC power supply bus,
   - determination of the ripple ($\tilde{V}pp_{H1}$) of the voltage (Vbus) of the DC power supply bus,
   - monitoring of the variation of the said mean value ($\overline{V}$) with respect to the said ripple ($\tilde{V}pp_{H1}$),
   - determination of a defect on the DC power supply bus as a function of the rate of the said variation, the said defect consisting of an anomaly on the inductor (L1) of the DC power supply bus, a power overload of the power converter, or advanced wear of the bus capacitor (Cbus).

2. Method according to Claim 1, **characterized in that** the monitoring step (E1) consists of monitoring a ratio ($\eta$) between the ripple ($\tilde{V}pp_{H1}$) of the voltage (Vbus) of the DC power supply bus and the mean value ($\overline{V}$) of the voltage (Vbus) of the DC power supply bus.

3. Method according to Claim 2, **characterized in that** the step (E1) of monitoring the ratio ($\eta$) consists in comparing the said rate ($V_\eta$) of variation with respect to a first rate ($v_1$) and to a second rate ($v_2$).

4. Method according to Claim 3, **characterized in that**, if the rate ($V_\eta$) of variation of the ratio is greater than the first rate ($v_1$), the determination step consists in determining whether the mean value ($\overline{V}$) of the voltage (Vbus) of the DC power supply bus has varied.

5. Method according to Claim 4, **characterized in that**, if the mean value ($\overline{V}$) of the voltage (Vbus) of the DC power supply bus has varied, the defect consists of an anomaly on a precharge relay (Sw) of the precharge circuit and **in that**, if the mean value ($\overline{V}$) of the voltage (Vbus) of the DC power supply bus has not varied, the defect consists of an anomaly on the inductor (L1).

6. Method according to Claim 3, **characterized in that**, if the rate ($V_\eta$) of variation of the ratio lies between the second rate ($v_2$) and the first rate ($v_1$), the determination step consists in determining whether the power (Pf) provided by the power converter has increased.

7. Method according to Claim 6, **characterized in that**, if the power (Pf) provided by the power converter has increased, the defect consists of a power overload of the power converter and **in that**, if the power provided by the power converter has not increased, the determination step comprises a step of comparing between a value dependent on the ratio ($\eta$) and a limit value (lim).

8. Method according to Claim 7, **characterized in that** according to the result of the comparison performed, the defect consists of advanced wear of the bus capacitor (Cbus) or a variation of the frequency ($f_R$) of the electrical distribution network (RD).

9. Method according to one of Claims 1 to 8, **characterized in that** the ripple is measured on the first harmonic of the voltage of the DC power supply bus and between two successive extreme values.

10. System for detecting a defect on the DC power supply bus of a power converter connected to an electrical distribution network (RD), the said power converter comprising a rectifier module (REC) connected to the electrical distribution network (RD) and intended to convert a voltage provided by the electrical distribution network (RD) into a voltage (Vbus) applied to the DC power supply bus, a bus capacitor (Cbus), an inductor (L1) and a precharge circuit connected to the DC power supply bus, the said system comprising:

  - first means for determining a mean value ($\overline{V}$) of the voltage (Vbus) of the DC power supply bus,
  - second means for determining the ripple ($\tilde{V}pp_{H1}$) of the voltage (Vbus) of the DC power supply bus,
  - means for monitoring the variation of the said mean value ($\overline{V}$) with respect to the said ripple ($\tilde{V}pp_{H1}$),
  - third means for determining a defect on the DC power supply bus as a function of the rate of the said variation, the said defect consisting of an anomaly on the inductor (L1) of the DC power supply bus, a power overload of the power converter, or advanced wear of the bus capacitor (Cbus).

11. System according to Claim 10, **characterized in that** it comprises fourth means for determining a ratio ($\eta$) between the ripple ($\tilde{V}pp_{H1}$) of the voltage (Vbus) of the DC power supply bus and the mean value ($\overline{V}$) of the voltage (Vbus) of the DC power supply bus.

12. System according to Claim 11, **characterized in that** the monitoring means are designed to compare a rate ($V_{\eta}$) of variation of the ratio with respect to a first rate ($v_1$) and to a second rate ($v_2$).

13. System according to Claim 12, **characterized in that**, if the rate ($V_{\eta}$) of variation of the ratio is greater than the first rate ($v_1$), the third determination means are designed to monitor the variation of the mean value ($\overline{V}$) of the voltage (Vbus) of the DC power supply bus.

14. System according to Claim 13, **characterized in that**, if the mean value ($\overline{V}$) of the voltage (Vbus) of the DC power supply bus has varied, the defect consists of an anomaly on a precharge relay (Sw) of the precharge circuit and **in that**, if the mean value ($\overline{V}$) of the voltage (Vbus) of the DC power supply bus has not varied, the defect consists of an anomaly on the inductor (L1).

15. System according to Claim 12, **characterized in that**, if the rate ($V_{\eta}$) of variation of the ratio lies between the second rate ($v_2$) and the first rate ($v_1$), the third determination means are designed to monitor the variation of the power (Pf) provided by the power converter.

16. System according to Claim 15, **characterized in that**, if the power (Pf) provided by the power converter has increased, the defect consists of a power overload of the power converter and **in that**, if the power provided by the power converter has not increased, the third determination means are designed to implement a comparison between a value dependent on the ratio ($\eta$) and a limit value (lim).

17. System according to Claim 16, **characterized in that**, according to the result of the comparison performed, the defect consists of advanced wear of the bus capacitor (Cbus) or a variation of the frequency ($f_R$) of the electrical distribution network (RD).

18. System according to one of Claims 10 to 17, **characterized in that** it comprises means for measuring or estimating the internal temperature of the bus capacitor (Cbus).

**Fig. 1**

**Fig. 2**

# EP 2 660 960 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 10244765